(19) Europäisches Patentamt
European Patent Office
Office européen des brevets

(11) **EP 3 605 512 A1**

(12) **EUROPEAN PATENT APPLICATION**
published in accordance with Art. 153(4) EPC

(43) Date of publication:
**05.02.2020 Bulletin 2020/06**

(51) Int Cl.:
**G09G 3/32** *(2016.01)*  **G09G 3/20** *(2006.01)*

(21) Application number: **17903923.5**

(22) Date of filing: **30.03.2017**

(86) International application number:
**PCT/JP2017/013155**

(87) International publication number:
**WO 2018/179196 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation**
**Chiyoda-ku**
**Tokyo 100-8310 (JP)**

(72) Inventors:
• **MACHIDA, Naoyuki**
  **Tokyo 100-8310 (JP)**
• **SHIBUE, Shigenori**
  **Tokyo 100-8310 (JP)**
• **ASAMURA, Yoshinori**
  **Tokyo 100-8310 (JP)**

(74) Representative: **Pfenning, Meinig & Partner mbB**
**Patent- und Rechtsanwälte**
**Theresienhöhe 11a**
**80339 München (DE)**

(54) **LED DISPLAY DEVICE AND METHOD FOR CORRECTING LUMINANCE THEREOF**

(57) It is an object of the present invention to provide an LED display device performing correction of a luminance of each LED element so as to suppress a decrease in image quality due to a variation of characteristics of each LED element, and a method for correcting a luminance thereof. The LED display device (100) includes a display part (10) including a display module including a plurality of LED elements, a first temperature detecting part (31), first and second aging display parts (21), (22) including at least one measurement LED element equivalent to the LED elements, a luminance measurement part (9) measuring a luminance of the measurement LED elements, a second temperature detecting part (32), an accumulated lighting time storage part (6) storing accumulated lighting times of the plurality of LED elements, a luminance decreasing rate storage part (11) storing a relationship between an accumulated lighting time of the measurement LED elements and a luminance decreasing rate of the measurement LED elements, and a luminance correction coefficient calculating part (12) calculating the luminance correction coefficient with reference to the plurality of LED elements, in which the luminance correction coefficient calculating part (12) corrects the luminance correction coefficient based on the temperatures detected by the first and second temperature detecting parts (31), (32).

FIG. 1

## Description

Technical Field

The present invention relates to an LED device and a method for correcting a luminance thereof, and more particularly relates to an LED display device which displays video information by controlling flashing of a plurality of LEDs (Light Emitting Diodes) arranged in a matrix and a method for correcting a luminance thereof.

Background Art

Display devices constituted by using LEDs are often used for outdoor and indoor advertisement display and the like due to technological development and cost reduction of LEDs. Until now, these LED display devices have mainly been used for displaying natural images and moving images of animations. In recent years, due to shortening of visual recognition distance along with narrowing of pixel pitch, the LED display device is used for a conference room, a monitoring application, and the like. Particularly in surveillance applications, PC images close to still images are often displayed. However, since the luminance of LED decreases as the lighting time increases, the luminance decreasing rate of each LED differs depending on the content of an image, and consequently, a luminance variation and a color variation occur in each pixel.

There is known a method of detecting the luminance of a display part of LED and correcting luminance data in order to reduce the above-mentioned luminance variation and color variation. There is also known a method of integrating the lighting time of LED and correcting the luminance based on a luminance correction coefficient already measured according to the integrated time (for example, see Patent Documents 1 and 2).

Prior Art Documents

Patent Documents

Patent Document 1: Japanese Patent Application Laid-Open No. 11-15437 (1999)
Patent Document 2: Japanese Patent Application Laid-Open No. 2006-330158

Summary

Problem to be Solved by the Invention

With regard to the luminance and color variation caused by difference in the lighting time of LED, it is possible to predict the luminance decreasing rate of LED to some extent by a life test or the like. However, it is difficult to predict differences in characteristics due to differences in LED manufacturing lot. In addition, although accuracy of correction can be improved by detecting the actual luminance of the LED display, it is necessary to display an image for luminance measurement, and in a 24-hour system, a necessity to stop operation occurs.

Although it is desirable that a time to stop the operation be as short as possible, if the time to stop the operation is shortened, there is a problem that accuracy of correction will not improve as a result, variations in luminance and color will remain, and image quality of the LED display part decreases. In addition, there is a problem that replacement with a new LED module is necessary in order to solve the decrease of image quality.

The present invention has been made to solve the problems as described above, and it is an object thereof to provide an LED display device that corrects a luminance of each LED element so as to suppress decrease in image quality due to a variation of characteristics of each LED element and a method for correcting a luminance thereof.

Means to Solve the Problem

An LED display device according to the present invention includes a display part including at least one display module including a plurality of LED elements, a first driving part driving the plurality of LED elements provided in the display part based on a video signal received from a video signal processing part, a first temperature detecting part detecting a temperature of the display part, a first aging display part including at least one measurement LED element equivalent to the LED element, a second aging display part including at least one measurement LED element equivalent to the LED element, a second driving part driving the measurement LED elements provided in the first aging display part and the second aging display part, a luminance measuring part measuring a luminance of the measurement LED elements provided in the first aging display part and the second aging display part, a second temperature detecting part detecting respective temperatures of the first aging display part and the second aging display part, an accumulated lighting time storage part storing an accumulated lighting time with respect to each of the plurality of LED elements provided in the display part, a luminance decreasing rate storage part storing a relationship between an accumulated lighting time of the measurement LED elements provided in the first aging display part and the second aging display part and a luminance decreasing rate of the measurement LED elements based on a measurement result of the luminance measuring part, a luminance correction coefficient calculating part calculating a luminance correction coefficient with reference to the accumulated lighting time storage part and the luminance decreasing rate storage part with respect to each of the plurality of LED elements provided in the display part, and a luminance correcting part controlling the first driving part so as to correct a luminance of each of the plurality of LED elements based on the luminance correction coefficient, wherein the luminance correction coefficient calculating part corrects the luminance correction coefficient of each of the plurality of LED elements provided in the display part based on a temperature detected by the first temperature detecting part and a temperature detected by the second temperature detecting part.

A method for correcting a luminance according to the present invention is a method for correcting a luminance of an LED display device, wherein the LED display device includes a display part including at least one display module including a plurality of LED elements, a first driving part driving the plurality of LED elements provided in the display part based on a video signal received from a video signal processing part, a first temperature detecting part, a first aging display part including at least one measurement LED element equivalent to the LED element, a second aging display part including at least one measurement LED element equivalent to the LED element, a second driving part driving the measurement LED elements provided in the first aging display part and the second aging display part, a luminance measuring part, a second temperature detecting part, an accumulated lighting time storage part, a luminance decreasing rate storage part, a luminance correction coefficient calculating part, and a luminance correcting part, the method for correcting a luminance including (a) step of detecting by the first temperature detecting part a temperature of the display part, (b) step of measuring by the luminance measuring part a luminance of the measurement LED elements provided in the first aging display part and the second aging display part, (c) step of detecting by the second temperature detecting part respective temperatures of the first aging display part and the second aging display part, (d) step of storing by the accumulated lighting time storage part an accumulated lighting time with respect to each of the plurality of LED elements provided in the display part, (e) step of storing by the luminance decreasing rate storage part a relationship between an accumulated lighting time of the measurement LED elements provided in the first aging display part and the second aging display part and a luminance decreasing rate of the measurement LED element based on a measurement result of the luminance measuring part, (f) step of calculating by the luminance correction coefficient calculating part a luminance correction coefficient with reference to the accumulated lighting time storage part and the luminance decreasing rate storage part (with respect to each of the plurality of LED elements provided in the display part, (g) step of controlling by the luminance correcting part the first driving part so as to correct a luminance of each of the plurality of LED elements based on the luminance correction coefficient, and (h) step of correcting by the luminance correction coefficient calculating part the luminance correction coefficient of each of the plurality of LED elements provided in the display part based on a temperature detected by the first temperature detecting part and a temperature detected by the second temperature detecting part.

Effect of the Invention

By the LED display device and the method for correcting a luminance thereof according to the present invention, the luminance correction coefficient is corrected in consideration of the difference in luminance decreasing rate due to the temperature difference between the display part and the first and second aging display parts. Thus, luminance correction with quite high accuracy can be performed for each of the plurality of LED elements provided in the display part. Therefore, it is possible to maintain the uniformity and the color uniformity of the luminance of the display part in long-term operation. Furthermore, in the LED display device and the method for correcting a luminance thereof according to the present invention, the first and second aging display parts are arranged. As a result, even if one of the aging display parts fails, the luminance correction of the display part can be correctly performed by using the accurate luminance decreasing rate and temperature obtained from the other aging display part. Therefore, the luminance of the display part can be stably and uniformly maintained in long-term operation.

The objects, features, aspects and advantages of the present invention will be more apparent from the following detailed description and the accompanying drawings.

Brief Description of Drawings

Fig. 1 is a functional block diagram of an LED display device according to a first embodiment.

Fig. 2 is a detailed block diagram of a periphery of a display part of the LED display device according to the first embodiment.

Fig. 3 is a detailed block diagram of a periphery of a first aging display part and a second aging display part of the LED display device according to the first embodiment.

Fig. 4 is a hardware configuration diagram of the LED display device according to the first embodiment.

Fig. 5 is a diagram for explaining a driving method of the LED display device according to the first embodiment.

Fig. 6 is a diagram illustrating a relationship between an accumulated lighting time and a luminance decreasing rate of a green LED element.

Fig. 7 is a diagram illustrating the luminance decreasing rate of a measurement LED element stored in a luminance decreasing rate storage part of the LED display device according to the first embodiment.

Fig. 8 is a diagram illustrating a temperature correction function of the LED display device according to the first embodiment.

Fig. 9 is a flowchart illustrating a luminance correction operation of the LED display device according to the first embodiment.

Fig. 10 is a diagram illustrating the luminance correction operation of the LED display device according to the first embodiment.

Fig. 11 is a diagram illustrating another example of the luminance correction operation of the LED display device according to the first embodiment.

Fig. 12 is a diagram illustrating a luminance decreasing rate of a measurement LED element stored in a luminance decreasing rate storage part of an LED display device according to a second embodiment.

Fig. 13 is a detailed block diagram of a periphery of a display part of an LED display device according to a third embodiment.

Description of Embodiments

<First Embodiment>

<Configuration>

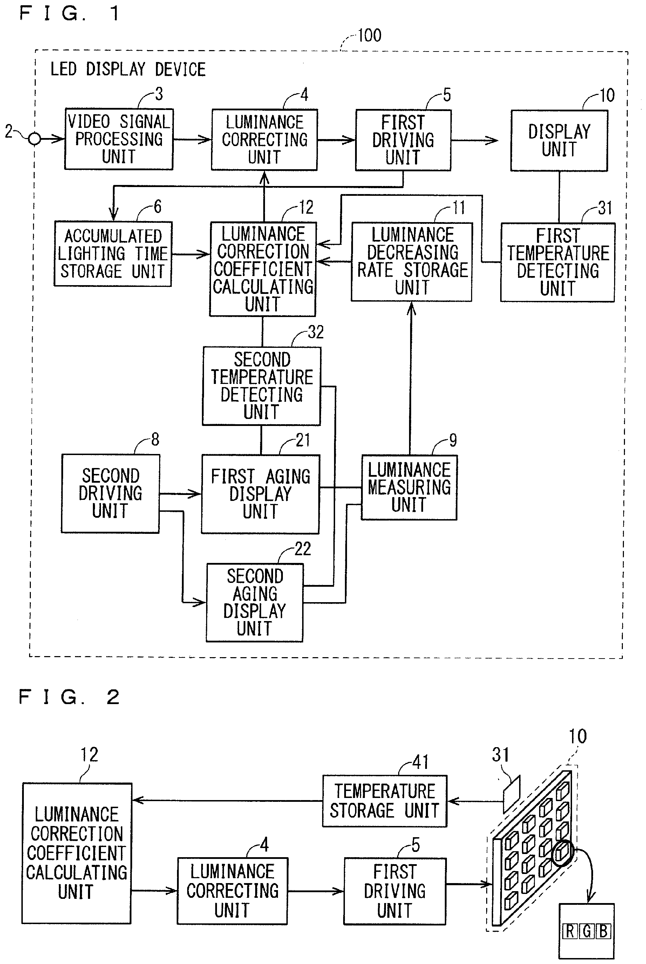

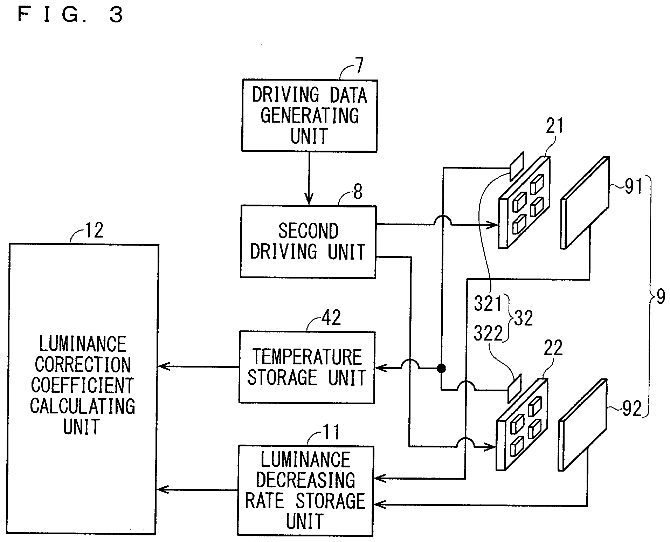

Fig. 1 is a functional block diagram of an LED display device 100 according to a first embodiment. Further, Fig. 2 is a more detailed block diagram of a periphery of a display part 10. Fig. 3 is a more detailed block diagram of a periphery of first and second aging display parts 21, 22.

As illustrated in Fig. 1, the LED display device 100 includes a display part 10, a first driving part 5, a first temperature detecting part 31, first and second aging display parts 21, 22, a second driving part 8, a luminance measuring part 9, a second temperature detecting part 32, a luminance decreasing rate storage part 11, an accumulated lighting time storage part 6, a luminance correction coefficient calculating part 12, and a luminance correcting part 4.

A display module provided in the display part 10 includes a plurality of unit pixels arranged in a matrix of M rows and N columns. The M rows and N columns are, for example, 4 rows and 4 columns as illustrated in Fig. 2, but are not limited thereto. In each unit pixel, three LED elements of red (R), green (G) and blue (B) are arranged. The first temperature detecting part 31 individually detects a temperature of each LED element provided in the display part 10. The temperature detected by the first temperature detecting part 31 is stored in a temperature storage part 41.

Note that in the first embodiment, although the display part 10 is configured to include one display module, in order to configure a large screen, the display part 10 may be configured to include a plurality of display modules. The configuration including the plurality of display modules will be described in a third embodiment.

The first driving part 5 drives a plurality of LED elements provided in the display part 10 based on a video signal received from a video signal processing part 3. A video signal is input to an input terminal 2 of the video signal processing part 3 from the outside of the LED display device 100. The video signal processing part 3 performs processing of selecting an area necessary for display, gamma correction processing, and the like on the video signal input from the outside.

Data stored in the accumulated lighting time storage part 6 are an accumulation of a time during which each LED element provided in the display part 10 is turned on, and is accumulated for every constant unit time. For example, when the unit time is one hour, for lighting of luminance with a duty ratio of 10%, a lighting time of 0.1 hour is stored every hour in the accumulated lighting time storage part 6. Here, as the duty ratio, one obtained for each unit time may be used. Further, the duty ratio may be an average duty ratio in a unit time. The current control method by the duty ratio will be described later.

Each of the first and second aging display parts 21, 22 includes four unit pixels arranged in two rows and two columns as illustrated in Fig. 3, for example. In each unit pixel, red, green, and blue measurement LED elements are arranged one by one. Note that although each of the first and second aging display parts 21, 22 will suffice to include at least one unit pixel, having a configuration including a plurality of unit pixels increases measured values of luminance and temperature measured in the measurement LED elements. Therefore, by averaging measured values, it is possible to suppress a variation of the measured values.

Further, it is assumed that the measurement LED elements of respective colors are LED elements equivalent to the LED elements of respective colors provided in the display part 10. Here, the equivalent LED element means an LED element manufactured with same specifications. In addition, the LED elements provided in the display part 10 and the measurement LED elements provided in each of the first and second aging display parts 21, 22 are desirably of the same manufacturing lot.

The second temperature detecting part 32 includes a temperature detecting part 321 for the first aging display part 21 and a temperature detecting part 322 for the second aging display part 22. The temperature detecting part 321 individually detects temperatures of the measurement LED elements provided in the first aging display part 21. Further, the temperature detecting part 322 individually detects temperatures of the measurement LED elements provided in the second aging display part 22. The temperatures detected by the second temperature detecting part 32 are stored in a temperature storage part 42.

The luminance measuring part 9 includes a luminance measuring part 91 for the first aging display part 21 and a luminance measuring part 92 for the second aging display part 22. The luminance measuring part 91 measures luminances of the measurement LED elements provided in the first aging display part 21. The luminance measuring part 92 measures luminances of the measurement LED elements provided in the second aging display part 22. The second driving part 8 drives the measurement LED elements provided in each of the first and second aging display parts 21, 22.

The luminance decreasing rate storage part 11 stores a relationship between an accumulated lighting time of the measurement LED elements and a luminance decreasing rate of the measurement LED elements based on measurement results of the luminance measuring part 9. Note that the luminance decreasing rate storage part 11 stores the above-mentioned relationship for both the first and second aging display parts 21, 22.

The luminance correction coefficient calculating part 12 calculates a luminance correction coefficient with reference to the accumulated lighting time storage part 6 and the luminance decreasing rate storage part 11 for each of the LED elements provided in the display part 10. A method of calculating the luminance correction coefficient will be described later.

The luminance correction coefficient calculating part 12 further corrects the luminance correction coefficient for each of the LED elements provided in the display part 10 based on a temperature detected by the first temperature detecting part 31 and a temperature detected by the second temperature detecting part 32. A correction method will be described later. The luminance correcting part 4 corrects an output of the video signal processing circuit part 3 according to the luminance correction coefficient calculated by the luminance correction coefficient calculating part 12.

As described later, the luminance correction coefficient calculating part 12 determines whether the first and second aging display parts 21, 22 are normal or failed, and calculates the luminance correction coefficient with reference to the luminance decreasing rate and the temperature of a normal aging display part. If both the first and second aging display parts 21, 22 are normal, the luminance correction coefficient calculating part 12 calculates the luminance correction coefficient with reference to the luminance decreasing rate and the temperature of the first aging display part 21, for example. When both the first and second aging display parts 21, 22 are normal, the luminance correction coefficient calculating part 12 may calculate two luminance correction coefficients with reference to each of the first and second aging display parts 21, 22. In this case, one of the luminance correction coefficients is used for luminance correction performed by the luminance correcting part 4.

Note that in the present description, hereinafter, the LED elements provided in the first display part 10 will be simply described as LED elements.

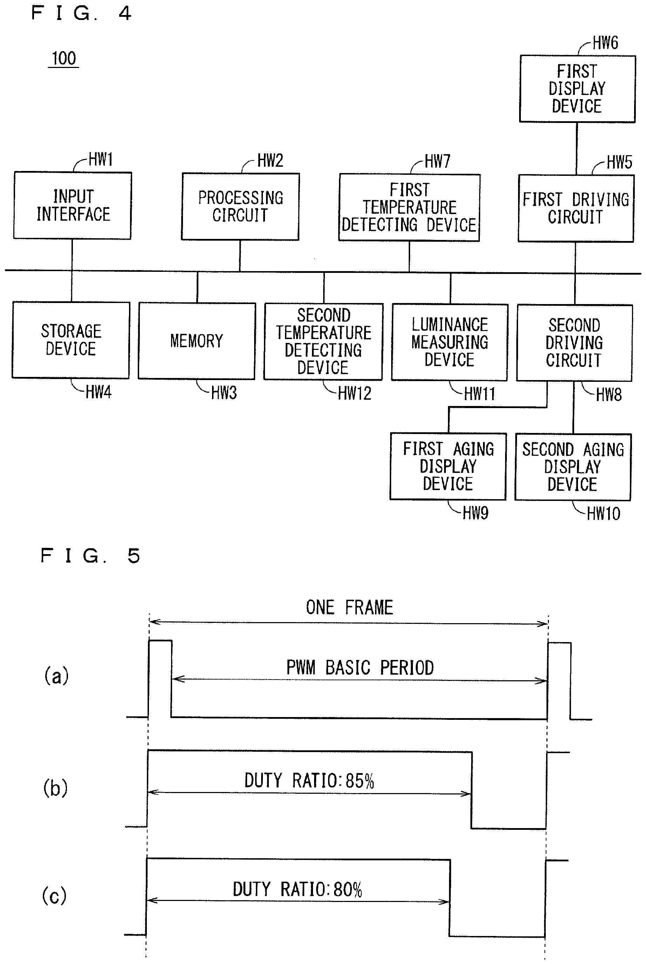

Fig. 4 is a hardware configuration diagram of the LED display device 100. As illustrated in Fig. 4, the LED display device 100 includes an input interface HW1, a processing circuit HW2, a memory HW3, a storage device HW4, a first driving circuit HW5, a display device HW6, a first temperature detecting device HW7, a second driving circuit HW8, a first aging display device HW9, a second aging display device HW10, a luminance measuring device HW11, and a first temperature detecting device HW12. Further, the above-mentioned components are connected to one another by a bus.

The video signal processing part 3, the luminance correction coefficient calculating part 12, and the luminance correcting part 4 are achieved by the processing circuit HW2. The processing circuit HW2 may be dedicated hardware. The processing circuit HW2 may also be a CPU (Central Processing Unit, which may also be called central processing device, processing device, arithmetic device, microprocessor, microcomputer, processor, or DSP) that executes a program stored in the memory HW3.

When the processing circuit HW2 is dedicated hardware, the processing circuit HW2 corresponds to, for example, a single circuit, a complex circuit, a programmed processor, a parallel programmed processor, an ASIC, an FPGA, or a combination thereof. Functions of respective parts of the video signal processing part 3, the luminance correction coefficient calculating part 12, and the luminance correcting part 4 may be achieved by respective individually provided processing circuits HW2, or the functions of the respective parts may be integrated and achieved by one processing circuit HW2.

When the processing circuit HW2 is a CPU, the functions of the video signal processing part 3, the luminance correction coefficient calculating part 12, and the luminance correcting part 4 are achieved by software, firmware, or a combination of software and firmware. Software and firmware are described as programs and stored in the memory HW3. The processing circuit HW2 implements the functions of the respective parts by reading and executing programs stored in the memory HW3. In addition, it can be said that these programs cause a computer to execute procedures and methods of the video signal processing part 3, the luminance correction coefficient calculating part 12, and the luminance correcting part 4. Here, the memory HW3 corresponds to, for example, non-volatile or volatile semiconductor memory such as RAM, ROM, flash memory, EPROM, or EEPROM, magnetic disk, flexible disk, optical disk, compact disk, mini disk, or DVD.

In addition, the functions of the video signal processing part 3, the luminance correction coefficient calculating part 12, and the luminance correcting part 4 may be partially achieved by dedicated hardware and partially achieved by software or firmware. Thus, the processing circuit can achieve each of the functions described above by hardware, software, firmware, or a combination thereof.

The first driving part 5 is achieved by the first driving circuit HW5. The first driving circuit HW5 may be dedicated hardware. The first driving circuit HW5 may also be a CPU that executes the program stored in the memory HW3.

When the first driving circuit HW5 is dedicated hardware, the first driving circuit HW5 corresponds to, for example, a single circuit, a complex circuit, a programmed processor, a parallel programmed processor, an ASIC, an FPGA, or a combination of them. When the first driving circuit HW5 is a CPU, a function of the first driving part 5 is achieved by software, firmware, or a combination of software and firmware. Software and firmware are described as programs and stored in the memory HW3. The first driving circuit HW5 implements the function of the first driving part 5 by reading and executing the programs stored in the memory HW3.

The second driving part 8 is achieved by the second driving circuit HW8. The second driving circuit HW8 may be' dedicated hardware. The second driving circuit HW8 may also be a CPU that executes a program stored in the memory HW3.

When the second driving circuit HW8 is dedicated hardware, the second driving circuit HW8 corresponds to, for example, a single circuit, a composite circuit, a programmed processor, a parallel programmed processor, an ASIC, an FPGA, or a combination of them. When the second driving circuit HW8 is a CPU, a function of the second driving part 8 is achieved by software, firmware, or a combination of software and firmware. Software and firmware are described as programs and stored in the memory HW3. The second driving circuit HW8 implements the function of the second driving part 8 by reading and executing a program stored in the memory HW3.

The display part 10 is achieved by the display device HW6. A configuration of the display device HW6 corresponds to the configuration of the display part 10 described above. The first aging display part 21 is achieved by the first aging display device HW9. A configuration of the first aging display device HW9 corresponds to the configuration of the first aging display part 21 described above. The second aging display part 22 is achieved by the second aging display device HW10. A configuration of the first aging display device HW10 corresponds to the configuration of the second aging display part 22 described above.

The luminance measuring part 9 is achieved by the luminance measuring device HW11. As described later, the luminance measuring device HW11 includes photodiodes by the number of measurement LED elements. By using a photodiode capable of measuring a wavelength in the visible range, it is possible to measure the luminance of the measurement LED element of each color.

The first and second temperature detecting parts 31, 32 are achieved by the first temperature detecting devices HW7, HW12, respectively. The first and second temperature detecting devices detect a temperature of each LED element by, for example, a thermocouple. Further, the first temperature detecting device HW7 may estimate the temperature of each LED element by measuring a forward voltage of each LED element. The second temperature detecting device HW12 is also similar to the first temperature detecting device HW7.

The accumulated lighting time storage part 6, the luminance decreasing rate storage part 11, and the temperature storage parts 41, 42 are achieved by the storage device HW4. The storage device HW4 is, for example, a non-volatile memory. Further, the input terminal 2 of the video signal processing part 3 is achieved by the input interface HW1.

Each LED element provided in the display part 10 is driven by a PWM (Pulse Width Modulation) method. Fig. 5 is a diagram illustrating an example of PWM driving. As illustrated in Fig. 5 (a), each LED element is driven by applying a pulse synchronized with a cycle of one frame period of a video signal. A pulse width is shorter than one frame period. The ratio of the pulse width to one frame of the video signal is called a duty ratio. Fig. 5 (b) illustrates a case of driving at a duty ratio of 85%. Further, Fig. 5(c) illustrates a case of driving at a duty ratio of 80%. By driving the LED element at a larger (smaller) duty ratio, the luminance of the LED element can be increased (decreased). The pulse width can be obtained by multiplying the PWM basic period by the duty ratio.

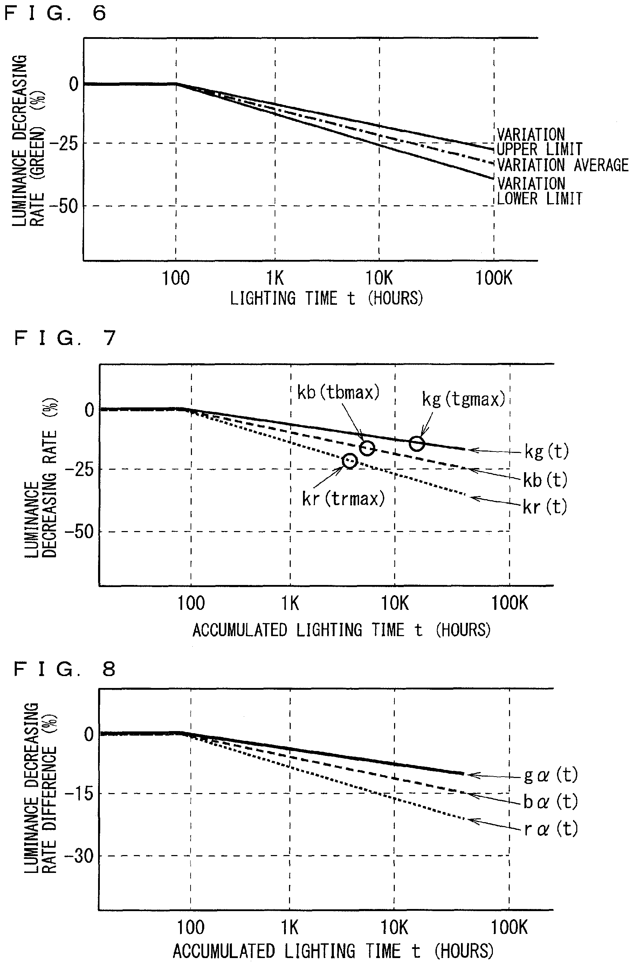

Fig. 6 is a diagram illustrating the relationship between the accumulated lighting time and the luminance decreasing rate of a green LED element. As illustrated in Fig. 6, the luminance of the LED element decreases together with the accumulated lighting time. Also, in general, as illustrated in Fig. 6, the luminance decreasing rate of the LED element tends to vary due to differences in LED manufacturing lot and BIN code. Conventionally, the luminance decreasing rate is determined by prior measurement, but in the first embodiment, it is configured that the first and second aging display parts 21, 22 are provided to measure the luminance decreasing rate in real time.

The second driving part 8 drives the measurement LED element at a maximum duty ratio in the display part 10. That is, a display pattern of the maximum duty ratio is input from a driving data generating part 7 to the second driving part 8, and the second driving part 8 drives the first and second aging display parts 21, 22 based on the display pattern. Here, the maximum duty ratio in the display part 10 is the maximum duty ratio among duty ratios at which the respective LED elements provided in the display part 10 are driven.

For example, if the maximum duty ratio in the display part 10 is 100%, the measurement LED elements provided in the first and second aging display parts 21, 22 are also driven at a 100% duty ratio. Thus, it is possible to make the accumulated lighting time of the measurement LED elements provided in each of the first and second aging display parts 21, 22 equal to or longer than the accumulated lighting times of all the LED elements provided in the display part 10.

Fig. 7 is a diagram illustrating the relationship between an accumulated lighting time and a luminance decreasing rate of the first and a second LED aging display parts 21, 21. The luminance measuring part 9 measures the luminance of the measurement LED element of each color in real time, and stores the luminance decreasing rate in the luminance decreasing rate storage part 11. As a result, as illustrated in Fig. 7, the luminance decreasing rate storage part 11 stores the relationship between an accumulated lighting time and a luminance decreasing rate of the measurement LED elements of respective colors up to the current time. In Fig. 7, the luminance decreasing rates of the red, green, and blue measurement LED elements are respectively indicated by $kr(t)$, $kg(t)$, and $kb(t)$ as a function of the accumulated lighting time $t$.

In addition, the luminance decreasing rate with respect to the accumulated lighting time of the LED is generally affected by temperature at the time of driving. Therefore, by considering differences between temperatures of the LED elements provided in the display part 10 and temperatures of the measurement LED elements provided in the first aging display part 21 or the second aging display part 22, luminance correction with higher accuracy can be achieved.

The temperatures of red, green, and blue LED elements in a pixel provided in the display part 10 are denoted by $tr$, $tg$, and $tb$, respectively. Further, the temperatures of red, green, and blue measurement LED elements provided in the first aging display part 21 or the second aging display part 22 are $tre$, $tge$, and $tbe$, respectively. Temperature differences $Tr$, $Tg$, $Tb$ between the LED elements of respective colors and the measurement LED element of respective colors are expressed by equation (1).

[Expression 1]

$$\left. \begin{array}{l} Tr = tr-tre \\ Tg = tg-tge \\ Tb = tb-tbe \end{array} \right\} \cdots (1)$$

Fig. 8 is a view illustrating temperature correction functions $r\alpha(t)$, $g\alpha(t)$, $b\alpha(t)$ regarding red, green, and blue LED elements, respectively. The temperature correction function $r\alpha(t)$ is a function that indicates a change of a difference in luminance decreasing rates of two red LED elements having different temperatures with respect to the accumulated lighting time. The same applies to $g\alpha(t)$ and $b\alpha(t)$. For example, as illustrated in Fig. 8, it can be seen that, when the accumulated lighting time is 10 K hours, a difference in luminance decreasing rates of 15% occurs between the two red LED elements having different temperatures.

Here, $r\alpha1$, $g\alpha1$, and $b\alpha1$ are respectively used as thresholds of temperature differences with respect to LED elements of respective colors. For example, with respect to the red LED element, when $Tr \geq r\alpha1$, there is an influence on the luminance decreasing rate by the temperature difference, and when $Tr < r\alpha1$, the influence on the luminance decreasing rate by the temperature difference is assumed negligible. Similarly, with respect to the green LED element, when $Tg \geq g\alpha1$, there is an influence on the luminance decreasing rate by the temperature difference, and when $Tg < g\alpha1$, the influence on the luminance decreasing rate by the temperature difference is assumed negligible. Similarly, with respect to the blue LED element, when $Tb \geq b\alpha1$, there is an influence on the luminance decreasing rate by the temperature difference, and when $Tb < b\alpha1$, the influence on the luminance decreasing rate by the temperature difference is assumed negligible.

When there is an influence on the luminance decreasing rate by the temperature difference, the luminance decreasing rates of the respective LED elements are corrected using the temperature correction functions $r\alpha(t)$, $g\alpha(t)$, $b\alpha(t)$ illustrated in Fig. 8. In this manner, it is possible to obtain the luminance decreasing rate more accurately.

That is, for example, if each LED continues to be driven in a state that the temperature difference between the green LED element and the green measurement LED element is Tg ≥ gα1, after 100 K hours in Fig. 6, the luminance of the green LED is determined to be further decreased 15% from the luminance value calculated from the LED aging display part. On the other hand, when Tg < gα1, it is determined that the luminance decreasing rate of the green LED element is the same as the luminance decreasing rate of the green measurement LED element.

<Operation>

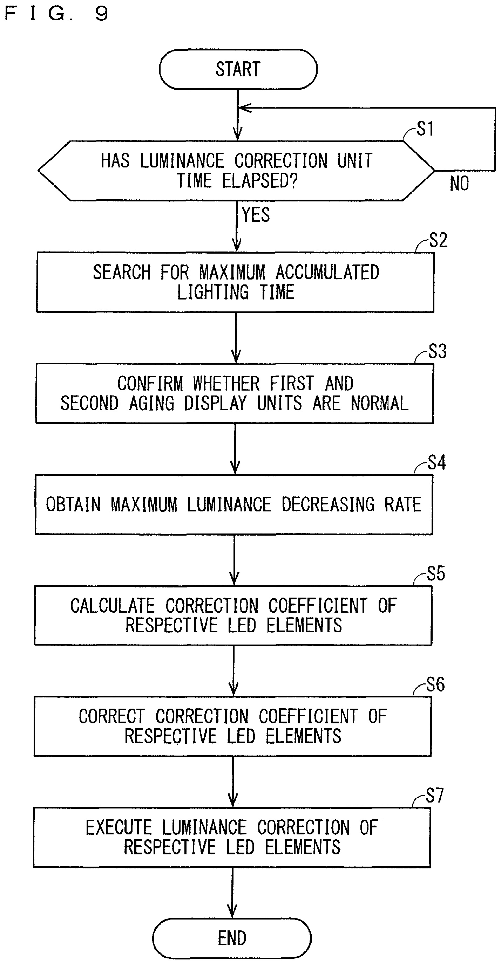

Hereinafter, luminance correction operation of the LED display device 100 according to the first embodiment will be described in detail. Fig. 9 is a flowchart illustrating the luminance correction operation of the LED display device 100. The luminance correction operation is performed every luminance correction unit time (for example, 100 minutes). First, the luminance correction coefficient calculating part 12 determines whether the luminance correction unit time has elapsed since the previous calculation of the luminance correction coefficient (step S1).

If the unit operation time has elapsed, the luminance correction coefficient calculating part 12 refers to the accumulated lighting time storage part 6 to search for maximum accumulated lighting times trmax, tgmax, tbmax for the LED elements of respective colors (step S2). Here, the maximum accumulated lighting time trmax is the maximum accumulated lighting time among the accumulated lighting times of all the red LED elements provided in the display part 10. Similarly, the maximum accumulated lighting time tgmax is the maximum accumulated lighting time among the accumulated lighting times of all the green LED elements provided in the display part 10. Similarly, the maximum accumulated lighting time tbmax is the maximum accumulated lighting time among the accumulated lighting times of all the blue LED elements provided in the display part 10.

Next, the luminance correction coefficient calculating part 12 refers to the luminance decreasing rate storage part 11 to determine whether each of the first and second aging display parts 21, 22 is normal or failed (step S3). The luminance correction coefficient calculating part 12 obtains luminance decreasing rates kr(trmax), kg(tgmax), kb(tbmax) corresponding to the maximum accumulated lighting times trmax, tgmax, tbmax of the LED elements of respective colors with respect to the luminance decreasing rates kr(t), kg(t), kg(t) of the first aging display part 21. If these luminance decreasing rates have decreased by a threshold value or more from the luminance decreasing rates at the time of previous luminance correction, a measurement LED element that is unlighted exists in the first aging display part 21, and thus it is determined that the first aging display part 21 is failed. The luminance correction coefficient calculating part 12 similarly performs failure determination on the second aging display part 22. Details of a method for failure determination will be described later.

When both the first and second aging display parts 21, 22 are normal, the luminance correction coefficient calculating part 12 uses the luminance decreasing rate and the temperature measurement result with respect to the first aging display part 21 to calculate the luminance correction coefficient.

On the other hand, when it is determined that either the first aging display part 21 or the second aging display part 22 is failed, the luminance decreasing rate and the temperature measurement result with respect to the normal aging display part are used to calculate the luminance correction coefficient.

In the following description, the luminance correction coefficient calculating part 12 uses the luminance decreasing rate and the temperature measurement result with respect to the first aging display part 21 to calculate the luminance correction coefficient unless otherwise specified.

Next, the luminance correction coefficient calculating part 12 obtains a maximum luminance decreasing rate krgb (step S4). The luminance correction coefficient calculating part 12 selects one of kr(trmax), kg(tgmax), and kb(tbmax) that has the largest luminance decreasing rate as the maximum luminance decreasing rate krgb. That is, the maximum luminance decreasing rate krgb is expressed by the following equation (2).

[Expression 2]

$$krgb = MAX(kr(trmax), kg(tgmax), kb(tbmax)) \quad \cdots (2)$$

Next, the luminance correction coefficient calculating part 12 calculates luminance correction coefficients hr, hg, gb for respective LED elements based on the maximum luminance decreasing rate krgb (step S5).

Next, the luminance correction coefficient calculating part 12 refers to the temperature storage part 41 storing temperatures of the display part 10 and the temperature storage part 42 storing temperatures of the first and second aging display parts 21, 22. When there is an influence on decrease of luminance by temperature difference, temperature correction functions rα(t), gα(t), bα(t) illustrated in Fig. 8 are used to correct temperature errors of luminance correction coefficients hr, hg, hb of respective LED elements calculated in step S5. Then, luminance correction coefficients hr2, hg2, hb2 in which the temperature error has been corrected are obtained (step S6).

Next, the luminance correcting part 4 executes luminance correction of each LED element based on the corrected luminance correction coefficients calculated by the luminance correction coefficient calculating part 12 (step S7). That is, the luminance correcting part 4 controls the first driving part 5 to correct the duty ratio of each LED element based on the corrected luminance correction coefficients. The luminance of an LED element can be corrected by correcting the duty ratio of the LED element based on the luminance correction coefficients.

Assuming that the current luminances of the LED elements of respective colors are Rp, Gp, and Bp, the luminance decreasing rates of respective colors at respective accumulated lighting times t are kr(t), kg(t), and kb(t), the maximum luminance decreasing rate is krgb, and the luminance correction coefficients are hr, hg, and hb, luminances Rcomp, Gcomp, Bcomp after the luminance correction of the LED elements of respective colors are represented by following equation (3).

[Expression 3]

$$\left. \begin{aligned} Rcomp &= Rp \times hr = Rp \times \frac{1}{(1-kr(t))} \times (1-krgb) \\ Gcomp &= Gp \times hg = Gp \times \frac{1}{(1-kg(t))} \times (1-krgb) \\ Bcomp &= Bp \times hb = Bp \times \frac{1}{(1-kb(t))} \times (1-krgb) \end{aligned} \right\} \cdots (3)$$

The current luminances Rp, Gp, Bp of the LED elements of respective colors in equation (3) are represented by equation (4), assuming that the initial luminances of the LED elements of respective colors are R0, G0, and B0.

[Expression 4]

$$\left. \begin{aligned} Rp &= R0 \times (1-kr(t)) \\ Gp &= G0 \times (1-kg(t)) \\ Bp &= B0 \times (1-kb(t)) \end{aligned} \right\} \cdots (4)$$

By substituting equation (4) into equation (3), the luminances Rcomp, Gcomp, Bcomp after the luminance correction of the LED elements of the respective colors are represented by equation (5). As illustrated in equation (5), the luminances Rcomp, Gcomp, Bcomp after the luminance correction of the LED elements of respective colors are uniformly corrected at the maximum luminance decreasing rate krgb with respect to the initial luminances R0, G0, B0.

[Expression 5]

$$\left. \begin{aligned} Rcomp &= R0 \times (1-krgb) \\ Gcomp &= G0 \times (1-krgb) \\ Bcomp &= B0 \times (1-krgb) \end{aligned} \right\} \cdots (5)$$

As described above, the luminance correction coefficient calculating part 12 calculates the luminance correction coefficients hr, hg, hb for all of the LED elements of respective colors provided in the display part 10.

Next, the luminance correction coefficient calculating part 12 calculates the temperature differences Tr, Tg, Tb for all of the LED elements of respective colors provided in the display part 10 with reference to the temperature storage parts 41, 42. Then, the luminance correction coefficient calculating part 12 corrects an error of the luminance decreasing rate due to the temperature differences with the temperature correction functions $g\alpha(t)$, $b\alpha(t)$, $r\alpha(t)$. The luminances Rcomp2, Gcomp2, Bcomp2 obtained by further correcting temperature errors of the luminances Rcomp, Gcomp, Bcomp of the LED elements of the respective colors are expressed by equation (6). That is, the luminance correction coefficients hr2, hg2, hb2 in which the temperature errors have been corrected are expressed by equation (7).

[Expression 6]

$$Rcomp2 = R0 \times (1-krgb) \times (1-r\alpha(t))$$
$$Gcomp2 = G0 \times (1-krgb) \times (1-g\alpha(t)) \Bigg\} \cdots (6)$$
$$Bcomp2 = B0 \times (1-krgb) \times (1-b\alpha(t))$$

[Expression 7]

$$hr2 = \frac{Rcomp2}{Rp} = hr \times (1-r\alpha(t))$$

$$hg2 = \frac{Gcomp2}{Gp} = hg \times (1-g\alpha(t)) \Bigg\} \cdots (7)$$

$$hb2 = \frac{Bcomp2}{Bp} = hb \times (1-b\alpha(t))$$

Here, when $Tr \geq r\alpha1$, $Tg \geq g\alpha1$, and $Tb \geq b\alpha1$, there is an influence on the luminance decreasing rate by the temperature differences, and when $Tr < r\alpha1$, $Tg < g\alpha1$, and $Tb < b\alpha1$, the influence on the luminance decreasing rate by the temperature differences is assumed negligible. That is, the correction coefficients $g\alpha(t)$, $b\alpha(t)$, $r\alpha(t)$ are applied only when $Tr \geq r\alpha1$, $Tg \geq g\alpha1$, and $Tb \geq b\alpha1$, and when $Tr < r\alpha1$, $Tg < g\alpha1$, and $Tb < b\alpha1$, $r\alpha(t) = g\alpha(t) = b\alpha(t) = 0$ is set in equation (6) and equation (7).

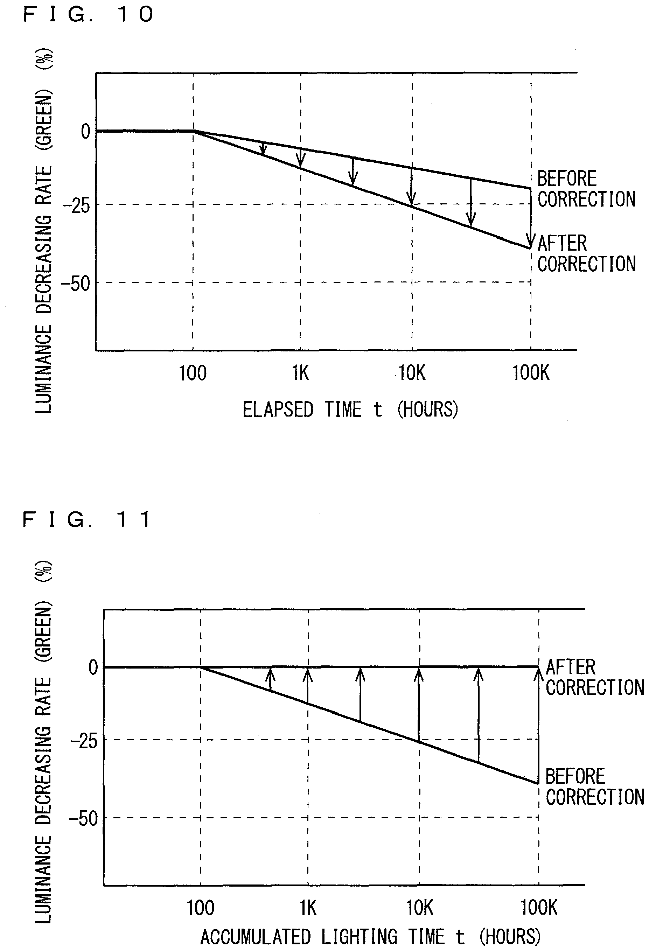

As described above, in the first embodiment, while the luminance correction is performed so as to unify the luminance of each LED element provided in the display part 13 to the luminance of the LED element having the largest decrease in luminance, the luminance correction may be performed so as to increase the luminance of each LED element and maintain the initial luminance, as illustrated in Fig. 11. In this case, the initial luminances R0, G0, B0 of the LED elements of respective colors are set to, for example, 50% of the maximum luminance.

The luminance correction coefficient calculating part 12 obtains the luminance decreasing rate by referring to the accumulated lighting time storage part 6 and the luminance decreasing rate storage part 11 with respect to each LED element. Then, the luminance correction coefficient calculating part 12 calculates the luminance correction coefficient so that the luminance of each LED element becomes the initial luminance.

Assuming that the current luminances of the LED elements of respective colors are Rp, Gp, and Bp, the luminance decreasing rates of respective colors at respective accumulated lighting times t are kr(t), kg(t), and kb(t), the maximum luminance decreasing rate is krgb, and the luminance correction coefficients are hr, hg, and hb, the luminances Rcomp, Gcomp, Bcomp after the luminance correction of the LED elements of respective colors are represented by following equation (8).

[Expression 8]

$$Rcomp = Rp \times hr = Rp \times \frac{1}{(1-kr(t))}$$

$$Gcomp = Gp \times hg = Gp \times \frac{1}{(1-kg(t))} \Bigg\} \cdots (8)$$

$$Bcomp = Bp \times hb = Bp \times \frac{1}{(1-kb(t))}$$

By substituting equation (4) into equation (8), the luminances Rcomp, Gcomp, Bcomp after the luminance correction of the LED elements of respective colors are expressed by equation (9). As expressed by equation (9), the luminances after the luminance correction of the LED elements of respective colors are corrected to the initial values.

[Expression 9]

$$
\left.\begin{array}{l}
\mathrm{Rcomp=R0} \\
\mathrm{Gcomp=G0} \\
\mathrm{Bcomp=B0}
\end{array}\right\} \cdots (9)
$$

Next, the luminance correction coefficient calculating part 12 calculates the temperature differences Tr, Tg, Tb for all of the LED elements of respective colors provided in the display part 10 with reference to the temperature storage parts 41, 42. Then, the luminance correction coefficient calculating part 12 corrects an error of the luminance decreasing rate due to the temperature differences with the temperature correction functions $g\alpha(t)$, $b\alpha(t)$, $r\alpha(t)$. The luminances Rcomp2, Gcomp2, Bcomp2 obtained by further correcting temperature errors of the luminances Rcomp, Gcomp, Bcomp of the LED elements of respective colors are expressed by equation (10). That is, the luminance correction coefficients hr2, hg2, hb2 in which the temperature errors have been corrected are expressed by equation (11).

[Expression 10]

$$
\left.\begin{array}{l}
\mathrm{Rcomp2=R0} \times \dfrac{1}{(1-r\,\alpha\,(t))} \\[2mm]
\mathrm{Gcomp2=G0} \times \dfrac{1}{(1-g\,\alpha\,(t))} \\[2mm]
\mathrm{Bcomp2=B0} \times \dfrac{1}{(1-b\,\alpha\,(t))}
\end{array}\right\} \cdots (10)
$$

[Expression 11]

$$
\left.\begin{array}{l}
\mathrm{hr2=}\dfrac{\mathrm{Rcomp2}}{\mathrm{Rp}}=\mathrm{hr} \times \dfrac{1}{(1-r\,\alpha\,(t))} \\[2mm]
\mathrm{hg2=}\dfrac{\mathrm{Gcomp2}}{\mathrm{Gp}}=\mathrm{hg} \times \dfrac{1}{(1-g\,\alpha\,(t))} \\[2mm]
\mathrm{hb2=}\dfrac{\mathrm{Bcomp2}}{\mathrm{Bp}}=\mathrm{hb} \times \dfrac{1}{(1-b\,\alpha\,(t))}
\end{array}\right\} \cdots (11)
$$

Note that, as described above, the correction coefficients $g\alpha(t)$, $b\alpha(t)$, $r\alpha(t)$ are applied only when Tr ≥ $r\alpha1$, Tg ≥ $g\alpha1$, and Tb ≥ $b\alpha1$, and when Tr < $r\alpha1$, Tg < $g\alpha1$, and Tb < $b\alpha1$, $r\alpha(t) = g\alpha(t) = b\alpha(t) = 0$ is set in equation (6) and equation (7).

A failure determination method for the first and second aging display parts 21, 22 in step 3 of Fig. 9 will be described. Here, failure determination on the first aging display part 21 will be described. If only one measurement LED element is provided in the first aging display part 21, a failure is determined when the measurement LED element is unlighted. When the first aging display part 21 includes a plurality of measurement LED elements, it is necessary to also assume a situation in which one measurement LED element is unlighted and the other measurement LED elements are lighted.

For example, assuming that the first aging display part 21 includes four measurement LED elements, when one measurement LED element is unlighted, the luminance measured by the luminance measuring part 9 decreases about 25% (= 1/4). Accordingly, a threshold value of the luminance decreasing rate used for determination of failure is set equal to or less than a value (for example, 25%) with which non-lighting of one measurement LED element can be determined. In other words, assuming that the number of measurement LED elements provided in the first aging display part 21 is N, the threshold value may be set to (100 - ((N - 1)/N × 100)) or less.

Note that, in the first embodiment, although the output of the video signal processing part 3 is corrected based on the luminance correction coefficient calculated for each LED element, the correction target is not limited to the output of the video signal processing part 3. It will suffice if the duty ratio or driving current of a driving signal of each LED element is finally corrected based on the correction coefficient.

Further, in the first embodiment, it has been described that the measurement LED elements provided in the first and second aging display parts 21, 22 are equivalent to the LED elements provided in the display part 10. The LED elements change in variation of luminance and wavelength depending on the manufacturing lot. Further, LED elements are classified according to luminance, wavelength and the like and by BIN code and the like. In order to improve the accuracy of correction of the luminance decreasing rate, it is preferable that the LED elements provided in the display part 10 and the measurement LED elements provided in the first and second aging display parts 21, 22 be of the same manufacturing lot and the same BIN code.

Further, in the first embodiment, the temperature correction functions $r\alpha(t)$, $g\alpha(t)$ and $b\alpha(t)$ are determined in advance, and correction is performed when there is an influence on the luminance decreasing rate by the temperature differences. By setting in advance temperature correction functions $r\alpha1(t)$, $g\alpha1(t)$, $b\alpha1(t)$ for a case where the temperature differences are small and temperature correction functions $r\alpha2(t)$, $g\alpha2(t)$, $b\alpha2(t)$ for a case where the temperature differences are small, more accurate correction is possible. For example, small threshold values $r\alpha1$, $g\alpha1$, $b\alpha1$ and large threshold values $r\alpha2$, $g\alpha2$, $b\alpha2$ are set in advance, and when $Tr < r\alpha1$, $Tg < g\alpha1$, and $Tb < b\alpha1$, the influence by the temperature differences is assumed negligible. When $r\alpha1 \leq Tr < r\alpha2$, $g\alpha1 \leq Tg < g\alpha2$, and $b\alpha1 \leq Tb < b\alpha2$, the luminance decreasing rate is corrected using the temperature correction functions $r\alpha1(t)$, $g\alpha1(t)$, $b\alpha1(t)$. When $Tr \geq r\alpha2$, $Tg \geq g\alpha2$, and $Tb \geq b\alpha2$, the luminance decreasing rate is corrected using the temperature correction functions $r\alpha2(t)$, $g\alpha2(t)$, $b\alpha2(t)$. In this manner, by performing correction using a plurality of temperature correction functions according to the magnitude of the temperature differences, it is possible to more accurately correct the difference in the luminance decreasing rate due to the temperature differences.

Further, in the first embodiment, for each of the LED elements provided in the display part 10, the temperature difference and the threshold value may be compared to determine whether or not to perform correction by the temperature correction function, but the display area of the display part 10 may be divided in advance into a plurality of areas, and the determination may be made for each area. Specifically, with respect to a representative LED element in each area, the temperature difference and the threshold value may be compared to determine whether or not to perform correction by the temperature correction function, and a determination result thereof may be applied to all LED elements arranged in that area. A division pattern of the display area of the display part 10 may be determined with reference to a temperature gradient of the LED element in the display area.

In addition, although the LED display device 100 of the first embodiment is configured to include two aging display parts (that is, the first and second aging display parts 21, 22), assuming an accidental failure, for example, the LED display device 100 may be configured to include three aging display parts. By including three or more aging display parts, it is possible to further improve reliability of the aging display part of the LED display device 100 against a failure.

Further, in the first embodiment, by providing the video signal processing part 3, the luminance correction coefficient calculating part 12, the luminance correcting part 4, the accumulated lighting time storage part 6, and the first and second aging display parts 21, 22 outside the display module provided in the display part 10, it becomes possible to apply the present invention to existing display modules. In addition, it is also possible to provide these parts in the display module.

<Effect>

The LED display device 100 according to the first embodiment includes the display part 10 including the at least one display module including the plurality of LED elements, the first driving part 5 driving the plurality of LED elements provided in the display part 10 based on a video signal received from the video signal processing part 3, the first temperature detecting part 31 detecting a temperature of the display part 10, the first aging display part 21 including the at least one measurement LED element equivalent to the LED element, the second aging display part 22 including the at least one measurement LED element equivalent to the LED element, the second driving part 8 driving the measurement LED elements provided in the first aging display part 21 and the second aging display part 22, the luminance measuring part 9 measuring a luminance of the measurement LED elements provided in the first aging display part 21 and the second aging display part 22, the second temperature detecting part 32 detecting respective temperatures of the first aging display part 21 and the second aging display part 22, the accumulated lighting time storage part 6 storing an accumulated lighting time with respect to each of the plurality of LED elements provided in the display part 10, the luminance decreasing rate storage part 11 storing a relationship between an accumulated lighting time of the measurement LED elements provided in the first aging display part 21 and the second aging display part 22 and a luminance decreasing rate of the measurement LED elements based on a measurement result of the luminance measuring part 9, the luminance correction coefficient calculating part 12 calculating a luminance correction coefficient with reference to the accumulated lighting time storage part 6 and the luminance decreasing rate storage part 11 with respect to each of the plurality of LED elements provided in the display part 10, and the luminance correcting part 4 controlling the first driving part 5 so as to correct a luminance of each of the plurality of LED elements based on the luminance correction coefficient, wherein the luminance correction coefficient calculating part 12 corrects the luminance correction coefficient of each of the plurality of LED elements provided in the display part 10 based on a temperature detected by the first temperature detecting part 31 and a temperature detected by the second temperature detecting part 32.

The LED display device 100 according to the first embodiment includes the aging display parts (first and second aging display parts 21, 22) in addition to the display part 10 that displays an image or the like. Then, luminance decreasing rates of the measurement LED elements disposed in the aging display parts are measured in real time. It is possible to obtain the luminance decreasing rate of each LED element by referring to the luminance decreasing rate of the measurement LED element in an accumulated lighting time of each LED element provided in the display part 10. Then, by calculating a luminance correction coefficient based on the luminance decreasing rate of each LED element, it is possible to keep the luminance of each LED element uniform. In the first embodiment, moreover, the luminance correction coefficient is corrected in consideration of a difference in luminance decreasing rates due to the temperature differences between the display part 10 and the aging display parts. Therefore, it is possible to perform luminance correction with quite high accuracy for each of the plurality of LED elements included in the display part 10, and thus it is possible to maintain uniformity of luminance and color uniformity of the display part 10 in long-term operation.

In addition, when only one aging display part is disposed, if a failure of the aging display part causes non-lighting of the measurement LED element or a significant decrease in luminance, an accurate luminance decreasing rate can no longer be obtained from the aging display parts. Therefore, luminance correction of the display part 10 cannot be performed correctly. Accordingly, in the first embodiment, the first and second aging display parts 21, 22 are disposed. Thus, even if one of the aging display parts fails, the luminance correction of the display part 10 can be correctly performed by using the accurate luminance decreasing rate and temperature obtained from the other aging display part. Therefore, luminance of the display part 10 can be stably and uniformly maintained in long-term operation.

Further, in the LED display device 100 according to the first embodiment, the luminance correction coefficient calculating part 12 detects a failure in each of the first aging display part 21 and the second aging display part 22 by referring to the luminance decreasing rate storage part 11, and when a failure is detected, the luminance correction coefficient calculating part 12 refers to information on a normal aging display part with respect to the luminance decreasing rate storage part 11 and the second temperature detecting part 32, so as to obtain the luminance decreasing rate.

Therefore, even if one of the aging display parts fails, the luminance correction of the display part 10 can be correctly performed by using the accurate luminance decreasing rate obtained from the other aging display part. Therefore, luminance of the display part 10 can be stably and uniformly maintained in long-term operation.

Further, in the LED display device 100 according to the first embodiment, the luminance correction coefficient calculating part 12 refers to a temperature detected by the first temperature detecting part 31 and a temperature detected by the second temperature detecting part 32, so as to correct the luminance correction coefficient based on predetermined temperature correction functions $r\alpha(t)$, $g\alpha(t)$, $b\alpha(t)$. Therefore, by predetermining the temperature correction functions, it is possible to accurately correct a difference in luminance decreasing rates due to a temperature difference by using the temperature correction functions.

Further, in the LED display device 100 according to the first embodiment, the temperature correction functions $r\alpha(t)$, $g\alpha(t)$, $b\alpha(t)$ are a function representing a difference in the luminance decreasing rates with respect to an accumulated lighting time in a case where a temperature difference of two LED elements equivalent to the LED elements is equal to or more than a predetermined temperature.

Therefore, in the first embodiment, when the temperature difference between the LED element and the measurement LED element is less than a predetermined temperature, the difference in the luminance decreasing rate due to the temperature difference is assumed negligible and correction by the temperature correction function is not performed. Thus, it is possible to reduce arithmetic processing of the luminance correction coefficient calculating part 12.

Further, in the LED display device 100 according to the first embodiment, the luminance correction coefficient calculating part 12 calculates a luminance correction coefficient of each of all the LED elements based on a luminance of the LED element having the luminance decreasing rate that is largest among the plurality of LED elements.

According to the first embodiment, as illustrated in Fig. 10, the luminance of each LED element provided in the display part 13 is unified to the luminance of the LED element with the largest decrease in luminance, and the display part 10 can maintain luminance uniformity and white balance, so as to improve variations in luminance. The method for correcting a luminance to perform unification to the luminance of the LED element having the largest decrease in luminance has an advantage that the initial luminance can be high. Further, conventionally, when the luminance of the display part 10 is constantly measured with a luminance sensor, there has been a problem such as blocking a display image of the display part by the luminance sensor. On the other hand, according to the first embodiment, in addition to the display part 10, the first and second aging display parts 21, 22 are disposed for luminance measurement. Therefore, a change over time of the LED elements can always be detected without blocking the display of the display part 10 by the luminance sensor.

Further, in the LED display device 100 according to the first embodiment, the luminance correction coefficient calculating part 12 may calculate the luminance correction coefficient so that each of the plurality of LED elements provided in the display part 10 maintains a preset luminance.

By the method of calculating the luminance correction coefficient, for example, by setting the initial luminance to 50% in advance, although the initial luminance becomes low, it is possible to maintain the luminance during operation constant. Therefore, in the long-term operation of the LED display device 100, it is possible to prevent the luminance of the display image of the display part 10 from being gradually reduced.

<Second Embodiment>

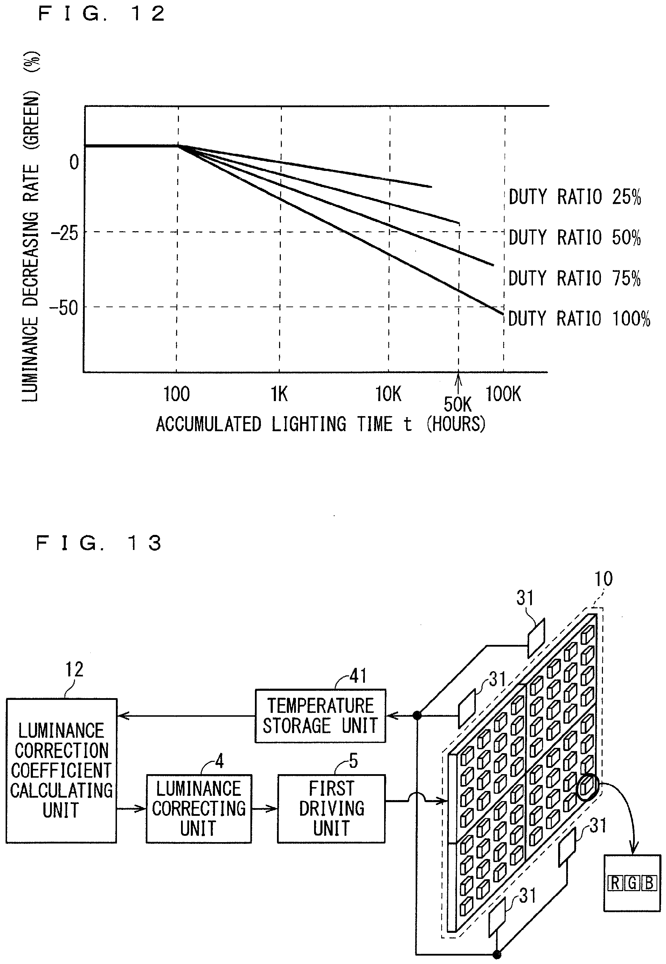

Fig. 12 is a diagram illustrating a luminance decreasing rate when a green LED element is driven at different duty ratios. As illustrated in Fig. 12, as the duty ratio increases, the luminance decreasing rate also increases.

In the first embodiment, it is assumed that the measurement LED elements are driven at a same duty ratio as a maximum duty ratio in the display part 10. In a second embodiment, each of first and second aging display parts 21, 22 includes a plurality of measurement LED elements, and respective LED elements are driven at duty ratios different from each other. For example, as illustrated in Fig. 12, each of the plurality of measurement LED elements is driven at a duty ratio of 100%, 75%, 50%, and 25%.

For example, it is assumed that the maximum accumulated lighting time tgmax of the green LED elements is 50 K, and a luminance decreasing rate storage part 11 stores the luminance decreasing rate illustrated in Fig. 12 for green measurement LED elements. In this case, a luminance correction coefficient calculating part 12 refers to the luminance decreasing rate storage part 11 to search for a duty ratio having an accumulated lighting time closest to the maximum accumulated lighting time (that is, 50 K) among the plurality of duty ratios. In Fig. 12, the duty ratio of 50% corresponds to this condition. Accordingly, the luminance correction coefficient calculating part 12 obtains the luminance decreasing rate (kg(tgmax)) with reference to the luminance decreasing rate with the duty ratio of 50%.

The second embodiment is the same as the first embodiment except for the driving method of the measurement LED element and the method of obtaining the luminance decreasing rates kr(trmax), kg(tgmax) and kb(tbmax), and thus the description is omitted.

<Effect>

In an LED display device 100 according to the second embodiment, at least one of the first aging display part 21 and the second aging display part 22 includes the plurality of measurement LED elements, a second driving part 8 drives each of the plurality of measurement LED elements at duty ratios different from each other, the luminance decreasing rate storage part 11 stores, for each duty ratio, a relationship between an accumulated lighting time of the plurality of measurement LED elements and the luminance decreasing rate of the measurement LED elements based on a measurement result of a luminance measuring part 9, and the luminance correction coefficient calculating part 12 refers to the luminance decreasing rate of the accumulated lighting time of the measurement LED elements closest to the accumulated lighting time of the LED element, so as to obtain the luminance decreasing rate of the LED element.

By driving each of the plurality of measurement LED elements at duty ratios different from each other, it becomes possible for the luminance correction coefficient calculating part 12 to refer to the luminance decreasing rate of the measurement LED element driven with the duty ratio closer to a driving condition of the LED element. Therefore, the luminance correction coefficient calculating part 12 can obtain the luminance decreasing rate more accurately.

<Third Embodiment

Fig. 13 is a detailed block diagram of a periphery of a display part 10 of an LED display device 100 in a third embodiment. In the first embodiment, the display part 10 is configured to include one display module. On the other hand, in the third embodiment, as illustrated in Fig. 13, the display part 10 is configured to include a plurality of display modules. The plurality of display modules are combined to constitute one screen.

In the third embodiment, a first driving part 5 selects an area corresponding to each display module from a video signal input from a luminance correcting part 4 and drives each display module. The plurality of display modules are connected, for example, in a daisy chain. In addition, a first temperature detecting part 31 individually detects temperatures of a plurality of LED elements provided in each display module.

In the first embodiment, the display part 10 is configured to include one display module, and for example, as illustrated in Fig. 1, the display module includes 16 LED elements of red, green, and blue, 48 LED elements in total. In this case, a luminance correction coefficient calculating part 12 calculates the luminance correction coefficient for each of the 48 LED elements.

In the third embodiment, the display part 10 includes four display modules, for example, as illustrated in Fig. 13. Since each display module includes 48 LED elements, the display part 10 includes 192 LED elements in total. In this case, the luminance correction coefficient calculating part 12 calculates the luminance correction coefficient for each of the 192 LED elements. The method of calculating the luminance correction coefficient in the third embodiment is the same as that in the first embodiment. As a result of the luminance of each LED element being corrected with the luminance correction coefficient, respective luminances of all the LED elements provided in the plurality of display modules become equal to each other.

That is, regardless of how many display modules the display part 10 is constituted of, the luminance correction coefficient calculating part 12 calculates the luminance correction coefficient for all the LED elements included in the display part 10. In the third embodiment, the configuration other than the number of display modules included in the display part 10 is the same as that of the first embodiment, and thus the description thereof is omitted.

<Effect>

In the LED display device 100 according to the third embodiment, the display part 10 includes the plurality of display modules, the plurality of display modules are combined to constitute one screen, the first temperature detecting part 31 detects a temperature of each of the plurality of display modules, and the luminance correction coefficient calculating part 12 calculates the luminance correction coefficient so that respective luminances of all the LED elements provided in the plurality of display modules are equal to each other.

Therefore, even when the display part 10 includes the plurality of display modules and the plurality of display modules are combined to form a large screen, luminance correction with quite high accuracy is possible similarly to the first embodiment, and thus it is possible to maintain uniformity of luminance and color uniformity of the large screen in long-term operation.

Furthermore, by disposing an accumulated lighting time storage part 6 and the luminance correction coefficient calculating part 12 outside the display part 10, even if part of display modules is replaced in the display part 10, it is possible to perform luminance correction of the entire display part 10. Therefore, even when the display module is replaced in long-term operation, it is possible to maintain uniformity of luminance and color uniformity of a large screen.

It should be noted that in the present invention, each embodiment can be freely combined within the scope of the invention, and each embodiment can be modified or omitted as appropriate. Although the present invention has been described in detail, the above description is illustrative in all aspects, and the present invention is not limited thereto. It is understood that innumerable modifications not illustrated can be envisaged without departing from the scope of the present invention.

Explanation of Reference Signs

| | |
|---|---|
| 2: | input terminal |
| 3: | video signal processing part |
| 4: | luminance correcting part |
| 5: | first driving part |
| 6: | accumulated lighting time storage part |
| 7: | driving data generating part |
| 8: | second driving part |
| 9, 91, 92: | luminance measuring part |
| 10: | display part |
| 11: | luminance decreasing rate storage part |
| 12: | luminance correction coefficient calculating part |
| 21: | first aging display part |
| 22: | first aging display part |
| 31: | first temperature detecting part |
| 32: | second temperature detecting part |
| 321, 322: | temperature detecting part |
| 41, 42: | temperature storage part |
| 100: | LED display device |
| HW1: | input interface |
| HW2: | processing circuit |
| HW3: | memory |
| HW4: | storage device |
| HW5: | first driving circuit |
| HW6: | display device |
| HW7: | first temperature detecting device |

HW8:      second driving circuit
HW9:      first aging display device
HW10:     second aging display device
HW11:     luminance measuring device
HW12:     first temperature detecting device


**Claims**

1.  An LED display device (100) comprising:

    a display part (10) including at least one display module including a plurality of LED elements;
    a first driving part (5) driving the plurality of LED elements provided in the display part (10) based on a video signal received from a video signal processing part (3);
    a first temperature detecting part (31) detecting a temperature of the display part (10);
    a first aging display part (21) including at least one measurement LED element equivalent to the LED element;
    a second aging display part (22) including at least one measurement LED element equivalent to the LED element;
    a second driving part (8) driving the measurement LED elements provided in the first aging display part (21) and the second aging display part (22);
    a luminance measuring part (9) measuring a luminance of the measurement LED elements provided in the first aging display part (21) and the second aging display part (22);
    a second temperature detecting part (32) detecting respective temperatures of the first aging display part (21) and the second aging display part (22);
    an accumulated lighting time storage part (6) storing an accumulated lighting time with respect to each of the plurality of LED elements provided in the display part (10);
    a luminance decreasing rate storage part (11) storing a relationship between an accumulated lighting time of the measurement LED elements provided in the first aging display part (21) and the second aging display part (22) and a luminance decreasing rate of the measurement LED element based on a measurement result of the luminance measuring part (9);
    a luminance correction coefficient calculating part (12) calculating a luminance correction coefficient with reference to the accumulated lighting time storage part (6) and the luminance decreasing rate storage part (11) with respect to each of the plurality of LED elements provided in the display part (10); and
    a luminance correcting part (4) controlling the first driving part (5) so as to correct a luminance of each of the plurality of LED elements based on the luminance correction coefficient,
    wherein the luminance correction coefficient calculating part (12) corrects the luminance correction coefficient of each of the plurality of LED elements provided in the display part (10) based on a temperature detected by the first temperature detecting part (31) and a temperature detected by the second temperature detecting part (32).

2.  The LED display device (100) according to claim 1, wherein
    the at least one display module comprises a plurality of display modules,
    the plurality of display modules are combined to constitute one screen,
    the first temperature detecting part (31) detects a temperature of each of the plurality of display modules, and
    the luminance correction coefficient calculating part (12) calculates the luminance correction coefficient so that the respective luminances of all of the LED elements provided in the plurality of display modules are equal to each other.

3.  The LED display device (100) according to claim 1 or 2, wherein
    the luminance correction coefficient calculating part (12) detects a failure in each of the first aging display part (21) and the second aging display part (22) by referring to the luminance decreasing rate storage part (11), and
    when a failure is detected, the luminance correction coefficient calculating part (12) refers to information on a normal aging display part with respect to the luminance decreasing rate storage part (11) and the second temperature detecting part (32), so as to obtain the luminance decreasing rate.

4.  The LED display device (100) according to any one of claims 1 to 3, wherein
    the luminance correction coefficient calculating part (12) refers to a temperature detected by the first temperature detecting part (31) and a temperature detected by the second temperature detecting part (32), so as to correct the luminance correction coefficient based on a predetermined temperature correction function.

**5.** The LED display device (100) according to claim 4, wherein
the temperature correction function is a function representing a difference in the luminance decreasing rate with respect to an accumulated lighting time in a case where a temperature difference between two LED elements equivalent to the LED element is larger than a predetermined temperature.

**6.** The LED display device (100) according to any one of claims 1 to 5, wherein
the luminance correction coefficient calculating part (12) calculates a luminance correction coefficient of each of all of the LED elements based on a luminance of the LED element having the luminance decreasing rate that is largest among the plurality of LED elements.

**7.** The LED display device (100) according to any one of claims 1 to 5, wherein
the luminance correction coefficient calculating part (12) calculates the luminance correction coefficient so that each of the plurality of LED elements provided in the display part maintains a preset luminance.

**8.** The LED display device (100) according to any one of claims 1 to 7, wherein
at least one of the first aging display part (21) and the second aging display part includes a plurality of the measurement LED elements,
the second driving part (8) drives each of the plurality of measurement LED elements at duty ratios different from each other,
the luminance decreasing rate storage part (11) stores, for each duty ratio, a relationship between an accumulated lighting time of the plurality of measurement LED elements and the luminance decreasing rate of the measurement LED elements based on a measurement result of the luminance measuring part, and
the luminance correction coefficient calculating part (12) refers to the luminance decreasing rate of the accumulated lighting time of the measurement LED element closest to the accumulated lighting time of the LED element, so as to obtain the luminance decreasing rate of the LED element.

**9.** A method for correcting a luminance of an LED display device (100), wherein
the LED display device (100) comprises:

a display part (10) including at least one display module including a plurality of LED elements;
a first driving part (5) driving the plurality of LED elements provided in the display part (10) based on a video signal received from a video signal processing part;
a first temperature detecting part (31);
a first aging display part (21) including at least one measurement LED element equivalent to the LED element;
a second aging display part (22) including at least one measurement LED element equivalent to the LED element;
a second driving part (8) driving the measurement LED elements provided in the first aging display part (21) and the second aging display part (22);
a luminance measuring part (9);
a second temperature detecting part (32);
an accumulated lighting time storage part (6);
a luminance decreasing rate storage part (11);
a luminance correction coefficient calculating part (12); and
a luminance correcting part (4),
the method for correcting a luminance comprising:

(a) step of detecting by the first temperature detecting part (31) a temperature of the display part (10);
(b) step of measuring by the luminance measuring part (9) a luminance of the measurement LED elements provided in the first aging display part (21) and the second aging display part (22);
(c) step of detecting by the second temperature detecting part (32) respective temperatures of the first aging display part (21) and the second aging display part (22);
(d) step of storing by the accumulated lighting time storage part (6) an accumulated lighting time with respect to each of the plurality of LED elements provided in the display part;
(e) step of storing by the luminance decreasing rate storage part (11) a relationship between an accumulated lighting time of the measurement LED elements provided in the first aging display part (21) and the second aging display part (22) and a luminance decreasing rate of the measurement LED element based on a measurement result of the luminance measuring part (9);
(f) step of calculating by the luminance correction coefficient calculating part (12) a luminance correction coefficient with reference to the accumulated lighting time storage part (6) and the luminance decreasing rate storage part (11) with respect to each of the plurality of LED elements provided in the display part (10);

(g) step of controlling by the luminance correcting part (12) the first driving part (5) so as to correct a luminance of each of the plurality of LED elements based on the luminance correction coefficient; and

(h) step of correcting by the luminance correction coefficient calculating part (12) the luminance correction coefficient of each of the plurality of LED elements provided in the display part (10) based on a temperature detected by the first temperature detecting part (31) and a temperature detected by the second temperature detecting part (32).

FIG. 1

FIG. 2

F I G. 3

DRIVING DATA GENERATING UNIT 7

SECOND DRIVING UNIT 8

LUMINANCE CORRECTION COEFFICIENT CALCULATING UNIT 12

TEMPERATURE STORAGE UNIT 42

LUMINANCE DECREASING RATE STORAGE UNIT 11

21

91

321
322
32

22

92

9

F I G. 4

100

```
┌─HW1              ┌─HW2              ┌─HW7                    ┌─HW6
┌──────────┐    ┌──────────┐    ┌──────────────┐        ┌──────────┐
│  INPUT   │    │PROCESSING│    │    FIRST     │        │  FIRST   │
│INTERFACE │    │ CIRCUIT  │    │ TEMPERATURE  │        │ DISPLAY  │
│          │    │          │    │DETECTING DEVICE│       │  DEVICE  │
└──────────┘    └──────────┘    └──────────────┘        └──────────┘
```

FIRST
DISPLAY
DEVICE

HW5
FIRST DRIVING
CIRCUIT

INPUT
INTERFACE

PROCESSING
CIRCUIT

FIRST
TEMPERATURE
DETECTING DEVICE

STORAGE
DEVICE

MEMORY

SECOND
TEMPERATURE
DETECTING
DEVICE

LUMINANCE
MEASURING
DEVICE

SECOND
DRIVING
CIRCUIT

HW4          HW3          HW12          HW11          HW8

FIRST AGING
DISPLAY
DEVICE

SECOND AGING
DISPLAY
DEVICE

HW9          HW10

F I G. 5

ONE FRAME

(a)

PWM BASIC PERIOD

(b)

DUTY RATIO: 85%

(c)

DUTY RATIO: 80%

F I G. 6

LUMINANCE DECREASING RATE (GREEN) (%)

VARIATION
UPPER LIMIT
VARIATION AVERAGE
VARIATION
LOWER LIMIT

LIGHTING TIME t (HOURS)

F I G. 7

LUMINANCE DECREASING RATE (%)

kb (tbmax)  kg (tgmax)

kg (t)

kb (t)

kr (trmax)

kr (t)

ACCUMULATED LIGHTING TIME t (HOURS)

F I G. 8

LUMINANCE DECREASING RATE DIFFERENCE (%)

g α (t)
b α (t)
r α (t)

ACCUMULATED LIGHTING TIME t (HOURS)

FIG. 9

```
                    ┌─────────────┐
                    │    START    │
                    └─────────────┘
                           │
                           ▼ ◄──────────────────┐
        ╱─────────────────────────────────╲ S1  │
       ╱  HAS LUMINANCE CORRECTION UNIT     ╲    │
       ╲        TIME ELAPSED?               ╱────┘
        ╲─────────────────────────────────╱  NO
                           │ YES
                           ▼                   S2
        ┌──────────────────────────────────────┐
        │    SEARCH FOR MAXIMUM ACCUMULATED     │
        │           LIGHTING TIME               │
        └──────────────────────────────────────┘
                           │
                           ▼                   S3
        ┌──────────────────────────────────────┐
        │        CONFIRM WHETHER FIRST AND      │
        │  SECOND AGING DISPLAY UNITS ARE NORMAL│
        └──────────────────────────────────────┘
                           │
                           ▼                   S4
        ┌──────────────────────────────────────┐
        │ OBTAIN MAXIMUM LUMINANCE DECREASING RATE│
        └──────────────────────────────────────┘
                           │
                           ▼                   S5
        ┌──────────────────────────────────────┐
        │   CALCULATE CORRECTION COEFFICIENT OF │
        │        RESPECTIVE LED ELEMENTS        │
        └──────────────────────────────────────┘
                           │
                           ▼                   S6
        ┌──────────────────────────────────────┐
        │    CORRECT CORRECTION COEFFICIENT OF  │
        │        RESPECTIVE LED ELEMENTS        │
        └──────────────────────────────────────┘
                           │
                           ▼                   S7
        ┌──────────────────────────────────────┐
        │     EXECUTE LUMINANCE CORRECTION OF   │
        │        RESPECTIVE LED ELEMENTS        │
        └──────────────────────────────────────┘
                           │
                           ▼
                    ┌─────────────┐
                    │     END     │
                    └─────────────┘
```

F I G. 1 0

F I G. 1 1

F I G. 1 2

F I G. 1 3

## INTERNATIONAL SEARCH REPORT

International application No.

PCT/JP2017/013155

### A. CLASSIFICATION OF SUBJECT MATTER
*G09G3/32*(2016.01)i, *G09G3/20*(2006.01)i

According to International Patent Classification (IPC) or to both national classification and IPC

### B. FIELDS SEARCHED

Minimum documentation searched (classification system followed by classification symbols)
G09G3/32, G09G3/20, H01L33/00, H05B37/02

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2017 |
| Kokai Jitsuyo Shinan Koho | 1971–2017 | Toroku Jitsuyo Shinan Koho | 1994–2017 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2016-218238 A (Mitsubishi Electric Corp.), 22 December 2016 (22.12.2016), entire text; all drawings & US 2016/0343349 A1 entire text; all drawings & CN 106169283 A | 1-9 |
| A | JP 2011-209480 A (Sony Corp.), 20 October 2011 (20.10.2011), paragraphs [0014] to [0019], [0077] to [0269]; fig. 1 to 23 & US 2011/0242143 A1 paragraphs [0058] to [0063], [0119] to [0309]; fig. 1 to 23 & CN 102208161 A | 1-9 |

☒ Further documents are listed in the continuation of Box C.     ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 16 June 2017 (16.06.17) | 27 June 2017 (27.06.17) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (January 2015)

## INTERNATIONAL SEARCH REPORT

| | International application No. |
|---|---|
| | PCT/JP2017/013155 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2017-32888 A (Mitsubishi Electric Corp.), 09 February 2017 (09.02.2017), paragraphs [0017] to [0065]; fig. 1 to 8 & US 2017/0042002 A1 paragraphs [0029] to [0076]; fig. 1 to 8 & CN 106448544 A | 1-9 |
| A | JP 2009-223145 A (Pioneer Corp.), 01 October 2009 (01.10.2009), entire text; all drawings (Family: none) | 3 |
| A | JP 2017-32889 A (Mitsubishi Electric Corp.), 09 February 2017 (09.02.2017), entire text; all drawings & US 2017/0042002 A1 & CN 106448544 A | 8 |
| A | JP 2008-122516 A (Matsushita Electric Industrial Co., Ltd.), 29 May 2008 (29.05.2008), paragraphs [0026] to [0039], [0055] to [0077]; fig. 1 to 3, 10 to 12 (Family: none) | 1-9 |
| A | JP 2014-102484 A (Lighthouse Technologies Ltd.), 05 June 2014 (05.06.2014), paragraphs [0015] to [0017], [0021] to [0023]; fig. 1 to 3 & US 2014/0139115 A1 paragraphs [0017] to [0019], [0023] to [0025]; fig. 1 to 3 & CN 103839512 A & KR 10-2015-0076201 A | 1-9 |
| E,A | WO 2017/061195 A1 (Mitsubishi Electric Corp.), 13 April 2017 (13.04.2017), entire text; all drawings (Family: none) | 1-9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11015437 A

- JP 2006330158 A